# EUROPEAN PATENT APPLICATION

(11) **EP 4 503 118 A1**
(43) Date of publication of application: **05.02.2025**
(21) Application number: 23775078.1
(22) Date of filing: 24.03.2023
(51) Int. Cl.: H01L 23/29, C08K 3/013, C08L 63/00, C08L 91/06, H01L 23/31

(54) **RESIN COMPOSITION FOR ENCAPSULATION AND METHOD FOR PRODUCING SINGLE-SIDED-ENCAPSULATION STRUCTURE**

(30) Priority: 25.03.2022 JP 2022050381
(71) Applicant: Sumitomo Bakelite Co., Ltd., Shinagawa-ku Tokyo 140-0002 (JP)
(72) Inventor: MATSUO, Makoto, Tokyo 140-0002 (JP)
(74) Representative: Müller-Boré & Partner Patentanwälte PartG mbB
(86) International application number: PCT/JP2023/011749
(87) International publication number: WO 2023/182485

(57) **Abstract**

There is provided a resin composition for encapsulation used for producing a single-sided encapsulation type structure by performing single-sided encapsulation on a motherboard on which at least one electronic device is mounted, the resin composition for encapsulation including a trifunctional or higher epoxy resin, a curing agent, a curing accelerator, an inorganic filler, and a wax, in which a molding shrinkage rate of the resin composition for encapsulation is equal to or less than 0.1%.

## Description

### TECHNICAL FIELD

The present invention relates to a resin composition for encapsulation and a method for producing a single-sided encapsulation structure using the resin composition for encapsulation. More specifically, the present invention relates to a resin composition for encapsulation used for producing a structure having a configuration in which an electronic component mounted on a substrate is resin-encapsulated, and a method for producing a structure.

### BACKGROUND ART

In recent years, laminated plates on which electrical or electronic components are mounted have been required to have a wide range of characteristics and to be highly sophisticated due to expansion of their application fields. For example, for an electronic control device such as an engine control unit or a control unit for an automatic transmission mounted on a vehicle, as a heat generation amount per unit volume increases due to transfer from a vehicle compartment to an engine room, on-engine, in-mission, or the like, or miniaturization of the electronic control device itself, a demand for heat resistance, vibration resistance, and impact resistance is further increased.

In order to satisfy such a requirement, for example, a technology of integrally encapsulating a circuit board on which an electronic component is mounted or a connector housing to which an external terminal is connected with resin has been disclosed (for example, Patent Document 1). According to such a technology, since the above-described circuit board or the like is encapsulated with a resin, it is advantageous in terms of heat resistance, vibration resistance, and impact resistance.

### RELATED DOCUMENT

### PATENT DOCUMENT

[Patent Document 1] International Publication No. 2005/004563

### SUMMARY OF THE INVENTION

### TECHNICAL PROBLEM

In a case where an electronic control device is a single-sided encapsulation type module, single-sided encapsulation, in which an upper surface of a substrate, that is, only a surface side where the electronic component is mounted, is encapsulated with a resin, is performed. In such bulk molding, there is a problem that warping occurs across the entire substrate after molding. This warping occurs due to a difference in balance between a thickness of the substrate and a thickness of resin encapsulation, and the warping occurs in one with stronger shrinkage force between the substrate after molding and an encapsulation resin. For example, in molding of a module that performs bulk encapsulation of the substrate, there is a problem that the module after molding warps towards a resin side.

The present invention has been made in view of the above-described circumstances, and an object of the present invention is to provide a resin composition for encapsulation in which a molding shrinkage rate during molding is reduced, and a method for producing a single-sided encapsulation type structure in which warping is reduced, which is produced by using the resin composition for encapsulation.

### SOLUTION TO PROBLEM

The present inventors have found that, a resin composition for encapsulation having a reduced molding shrinkage rate can be obtained by having a specific blending, and that warping of a single-sided encapsulation type structure produced by using the resin composition for encapsulation is reduced, thereby completing the present invention.

According to the present invention, there is provided a resin composition for encapsulation used for producing a single-sided encapsulation type structure by performing single-sided encapsulation on a motherboard on which at least one electronic device is mounted, the resin composition for encapsulation including a trifunctional or higher epoxy resin, a curing agent, a curing accelerator, an inorganic filler, and a wax, in which a molding shrinkage rate of the resin composition for encapsulation is equal to or less than 0.1%.

In addition, according to the present invention, there is provided a method for producing a single-sided encapsulation structure, the method including a step of preparing a structure including a motherboard and an electronic device mounted on one surface of the motherboard, and a step of obtaining a single-sided encapsulation structure by encapsulating the surface of the structure, on which the electronic device is mounted, with a resin composition for encapsulation, in which the resin composition for encapsulation contains a trifunctional or higher epoxy resin, a curing agent, a curing accelerator, an inorganic filler, and a wax, and a molding shrinkage rate of the resin composition for encapsulation is equal to or less than 0.1%.

### ADVANTAGEOUS EFFECTS OF INVENTION

An object of the present invention is to provide a resin composition for encapsulation in which a molding shrinkage rate during molding is reduced, and a method for producing a single-sided encapsulation type structure in which warping is reduced, which is produced by using the resin composition for encapsulation.

### DESCRIPTION OF EMBODIMENTS

Hereinafter, embodiments of the present invention will be described.

### [Resin composition for encapsulation]

The resin composition for encapsulation according to the present embodiment is used for producing a single-sided encapsulation type structure in which a motherboard where at least one electronic device is mounted, by encapsulating an upper surface of the motherboard, that is, a surface side on which the electronic device is mounted. The resin composition for encapsulation according to the present embodiment contains a trifunctional or higher epoxy resin, a curing agent, a curing accelerator, an inorganic filler, and a wax, and a molding shrinkage rate of the resin composition is equal to or less than 0.1%.

The resin composition for encapsulation according to the present embodiment has a molding shrinkage rate equal to or less than 0.1% by including a combination of the above-described specific components. In single-sided encapsulation type structure obtained by using such a resin composition for encapsulation with a molding shrinkage rate as an encapsulant, warping, particularly warping toward an encapsulation resin side is reduced, and thus a single-sided encapsulation type structure with excellent reliability is obtained. Hereinafter, each component used in the resin composition for encapsulation according to the present embodiment will be described.

### (Polyfunctional epoxy resin)

A trifunctional or higher polyfunctional epoxy resin used in the resin composition for encapsulation according to the present embodiment refers to a compound having three or more epoxy groups in one molecule. By using the trifunctional or higher epoxy resin, it is possible to improve heat resistance of a cured product obtained by curing the epoxy resin. A functionality of the epoxy resin is preferably 3 to 20-valent. Examples of bifunctional or higher epoxy resin used in the present embodiment include a bisphenol A-type epoxy resin, a bisphenol F-type epoxy resin, a tetramethylbisphenol F-type epoxy resin, a hydroquinone-type epoxy resin, a biphenyl-type epoxy resin, a bisphenol fluorene-type epoxy resin, a bisphenol S-type epoxy resin, a bisthioether-type epoxy resin, a resorcinol-type epoxy resin, a biphenyl aralkyl-type epoxy resin, a naphthalenediol-type epoxy resin, a phenol novolac-type epoxy resin, an aromatic-modified phenol novolac-type epoxy resin, a cresol novolac-type epoxy resin, an alkyl novolac-type epoxy resin, a bisphenol novolac-type epoxy resin, a naphthol novolac-type epoxy resin, a β-naphthol aralkyl-type epoxy resin, a dinaphthol aralkyl-type epoxy resin, an α-naphthol aralkyl-type epoxy resin, a trisphenylmethane-type epoxy resin, an alkylene glycol-type epoxy resin, an aliphatic cyclic epoxy resin, diaminodiphenylmethane tetraglycidylamine, an aminophenol-type epoxy resin, a urethane-modified epoxy resin, and an oxazolidone ring-containing epoxy resin. However, the bifunctional or higher epoxy resin is not limited to these. From a viewpoint in which excellent heat resistance is provided, a naphthalenediol-type epoxy resin, a phenol novolac-type epoxy resin, an aromatic-modified phenol novolac-type epoxy resin, a cresol novolac-type epoxy resin, an α-naphthol aralkyl-type epoxy resin, a dicyclopentadiene-type epoxy resin, an oxazolidone ring-containing epoxy resin, or the like is preferable. This may be used alone or in combination with two or more kinds thereof.

The content of the epoxy resin is preferably equal to or more than 5% by mass and equal to or less than 40% by mass, and more preferably equal to or more than 10% by mass and equal to or less than 20% by mass, with respect to the entire resin composition for encapsulation.

### (Curing agent)

The resin composition for encapsulation of the present embodiment includes a curing agent for three-dimensionally crosslinking the epoxy resin. As the curing agent, for example, a phenol resin-based curing agent is preferably used. Examples of the phenol resin-based curing agent include novolac type resins such as a phenol novolac resin, a cresol novolac resin, and a naphthol novolac resin; polyfunctional phenol resins such as a triphenolmethane type phenol resin; modified phenol resins such as a terpene-modified phenol resin and a dicyclopentadiene-modified phenol resin; aralkyl type resins such as a phenol aralkyl resin having a phenylene skeleton and/or a biphenylene skeleton and a naphthol aralkyl resin having a phenylene skeleton and/or biphenylene skeleton; and bisphenol compounds such as bisphenol A and bisphenol F. Regarding these, one kind thereof may be used alone, or two or more kinds thereof may be used in combination. With such a phenol resin-based curing agent, the balance between flame resistance, moisture resistance, electrical characteristics, curability, storage stability, and the like is improved. In particular, from the viewpoint of curability, for example, the hydroxyl group equivalent of the phenol resin-based curing agent can be set to be equal to or more than 90 g/eq and equal to or less than 250 g/eq.

In addition to the above-described phenol resin-based curing agent, for example, a polyaddition-type curing agent, a catalyst-type curing agent, a condensation-type curing agent, or the like may be used.

Examples of the polyaddition-type curing agent include polyamine compounds, including aliphatic polyamines such as diethylenetriamine (DETA), triethylenetetramine (TETA) and methaxylenediamine (MXDA), aromatic polyamines such as diaminodiphenylmethane (DDM), m-phenylenediamine (MPDA), and diaminodiphenylsulfone (DDS), dicyandiamide (DICY), and an organic acid dihydrazide; acid anhydrides, including alicyclic acid anhydrides such as hexahydrophthalic anhydride (HHPA) and methyltetrahydrophthalic anhydride (MTHPA), and aromatic acid anhydrides such as trimellitic anhydride (TMA), pyromellitic anhydride (PMDA), and benzophenonetetracarboxylic acid (BTDA); polyphenol compounds such as a novolac type phenol resin and a phenol polymer; polymercaptan compounds such as a polysulfide, a thioester, and a thioether; isocyanate compounds such as an isocyanate prepolymer and a blocked isocyanate; and organic acids such as a carboxylic acid-containing polyester resin.

Examples of the catalyst-type curing agent include tertiary amine compounds such as benzyldimethylamine (BDMA) and 2,4,6-trisdimethylaminomethylphenol (DMP-30); imidazole compounds such as 2-methylimidazole and 2-ethyl-4-methylimidazole (EMI24); and Lewis acids such as a BF₃ complex.

Examples of the condensation-type curing agent include a resol resin, a urea resin such as a methylol group-containing urea resin; and a melamine resin such as a methylol group-containing melamine resin.

In a case where such other curing agents are used in combination with the above-described phenol resin-based curing agent, the lower limit value of the content of the phenol resin-based curing agent is preferably equal to or more than 20% by mass, more preferably equal to or more than 30% by mass, and particularly preferably equal to or more than 50% by mass, with respect to all the curing agents. When the blending proportion is within the above-described range, satisfactory fluidity can be exhibited while maintaining heat resistance. The upper limit value of the content of the phenol resin-based curing agent is not particularly limited; however, the upper limit value is preferably equal to or less than 100% by mass with respect to all the curing agents.

The lower limit value of the total value of the contents of the curing agents in the resin composition for encapsulation according to the present invention is not particularly limited; however, the lower limit value is preferably equal to or more than 0.8% by mass, and more preferably equal to or more than 1.5% by mass, with respect to the entire resin composition for encapsulation. When the lower limit value of the blending proportion is within the above-described range, satisfactory curability can be obtained. Furthermore, the upper limit value of the total value of the contents of the curing agents with respect to the resin composition for encapsulation is not particularly limited; however, the upper limit value is preferably equal to or less than 12% by mass, and more preferably equal to or less than 10% by mass, with respect to the entire resin composition for encapsulation.

Incidentally, it is preferable that the phenol resin as a curing agent and the above-described polyfunctional epoxy resin are blended such that the equivalent ratio (EP)/(OH) of the number of epoxy groups (EP) in the resin composition for encapsulation and the number of phenolic hydroxyl groups (OH) of all the phenol resins is equal to or more than 0.8 and equal to or less than 1.3. When the equivalent ratio is within the above-described range, sufficient curing characteristics can be obtained when molding the obtained resin composition for encapsulation. However, in a case where a resin other than a phenol resin, which may react with the epoxy resin, is used in combination, the equivalent ratio may be adjusted as appropriate.

### (Curing accelerator)

Regarding the curing accelerator that is used for the resin composition for encapsulation of the present embodiment, it is preferable to use imidazoles. The imidazoles can include, for example, one kind or two or more kinds selected from imidazole compounds such as imidazole, 2-methylimidazole, 2-undecylimidazole, 2-heptadecylimidazole, 1,2-dimethylimidazole, 2-ethyl-4-methylimidazole, 2-phenylimidazole, 2-phenyl-4-methylimidazole, 1-benzyl-2-phenylimidazole, 1-benzyl-2-methylimidazole, 1-cyanoethyl-2-methylimidazole, 1-cyanoethyl-2-ethyl-4-methylimidazole, 1-cyanoethyl-2-undecylimidazole, 1-cyanoethyl-2-phenylimidazole, 2-phenyl-4,5-dihydroxydimethylimidazole, and 2-phenyl-4-methyl-5-hydroxymethylimidazole; 1-cyanoethyl-2-undecylimidazolium trimellitate, 1-cyanoethyl-2-phenylimidazolium trimellitate, 2,4-diamino-6-[2'-methylimidazolyl(1')]-ethyl-s-triazine, 2,4-diamino-6-[2'-undecylimidazolyl(1')]-ethyl-s-triazine, 2,4-diamino-6-[2'-ethyl-4-methylimidazolyl(1')]-ethyl-s-triazine, isocyanuric acid adduct of 2,4-diamino-6-[2'-methylimidazolyl(1')]-ethyl-s-triazine, isocyanuric acid adduct of 2-phenylimidazole, and isocyanuric acid adduct of 2-methylimidazole.

In a case where imidazoles are used as the curing accelerator, the content of the imidazoles is preferably equal to or more than 0.01% by mass, more preferably equal to or more than 0.03% by mass, and particularly preferably equal to or more than 0.05% by mass, with respect to the entire resin composition for encapsulation. By setting the content of the imidazoles to be equal to or more than the above-described lower limit value, the temperature cycle resistance of the obtained encapsulant can be enhanced more effectively. It is also possible to enhance the curability at the time of encapsulation molding. On the other hand, the content of the imidazoles is preferably equal to or less than 2.0% by mass, more preferably equal to or less than 1.0% by mass, and particularly preferably equal to or less than 0.5% by mass, with respect to the entire resin composition for encapsulation. By setting the content of the imidazoles to be equal to or less than the above-described upper limit value, the fluidity at the time of transfer molding can be enhanced, which can contribute to enhancement of the filling property.

The curing accelerator can further include, in addition to the imidazoles, for example, one kind or two or more kinds selected from phosphorus atom-containing compounds such as an organic phosphine, a tetra-substituted phosphonium compound, a phosphobetaine compound, an adduct of a phosphine compound and a quinone compound, and an adduct of a phosphonium compound and a silane compound; and amine-based curing accelerators other than imidazoles, such as 1,8-diazabicyclo(5,4,0)undecene.

Examples of the organic phosphine that can be used for the resin composition for encapsulation include primary phosphines such as ethylphosphine and phenylphosphine; secondary phosphines such as dimethylphosphine and diphenylphosphine; and tertiary phosphines such as trimethylphosphine, triethylphosphine, tributylphosphine, and triphenylphosphine.

Examples of the tetra-substituted phosphonium compound that can be used for the resin composition for encapsulation include a compound represented by the following General Formula (4).

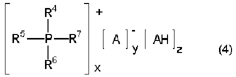

In the above-described General Formula (4), P represents a phosphorus atom. R⁴, R⁵, R⁶, and R⁷ each represent an aromatic group or an alkyl group. A represents an anion of an aromatic organic acid having at least one unit of any one functional group selected from a hydroxyl group, a carboxyl group, and a thiol group in the aromatic ring. AH represents an aromatic organic acid having at least one unit of any one functional group selected from a hydroxyl group, a carboxyl group, and a thiol group in the aromatic ring. x and y are numbers of 1 to 3; z is a number of 0 to 3, and x = y.

The compound represented by General Formula (4) is obtained, for example, as follows; however, the compound is not limited to this. First, a tetra-substituted phosphonium halide, an aromatic organic acid, and a base are mixed with an organic solvent, the mixture is uniformly mixed, and an aromatic organic acid anion is generated in the solution system. Next, when water is added thereto, a compound represented by General Formula (4) can be precipitated. In the compound represented by General Formula (4), R⁴, R⁵, R⁶, and R⁷, all of which are bonded to a phosphorus atom, are each preferably a phenyl group, AH is preferably a compound in which a hydroxyl group is bonded to an aromatic ring, that is, phenols, and A is preferably an anion of the phenols. Examples of the above-described phenol include monocyclic phenols such as phenol, cresol, resorcin, and catechol; condensed polycyclic phenols such as naphthol, dihydroxynaphthalene, and anthraquinol; bisphenols such as bisphenol A, bisphenol F, and bisphenol S; and polycyclic phenols such as phenylphenol and biphenol.

Examples of the phosphobetaine compound that is used as the curing accelerator include a compound represented by the following General Formula (5).

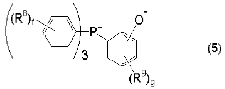

In the above-described General Formula (5), R⁸ represents an alkyl group having 1 to 3 carbon atoms, and R⁹ represents a hydroxyl group. f is a number of 0 to 5, and g is a number of 0 to 3.

The compound represented by General Formula (5) is obtained, for example, as follows. The compound is obtained through a step of first bringing a triaromatic-substituted phosphine, which is a tertiary phosphine, into contact with a diazonium salt and substituting the triaromatic-substituted phosphine with a diazonium group of the diazonium salt. However, the compound is not limited to this.

Examples of the adduct of a phosphine compound and a quinone compound, which is used as the curing accelerator, include a compound represented by the following General Formula (6) .

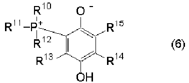

In the above-described General Formula (6), P represents a phosphorus atom. R¹⁰, R¹¹, and R¹² each represent an alkyl group having 1 to 12 carbon atoms or an aryl group having 6 to 12 carbon atoms, and they may be identical with or different from each other. R¹³, R¹⁴, and R¹⁵ each represent a hydrogen atom or a hydrocarbon group having 1 to 12 carbon atoms and may be the same as or different from each other, or R¹⁴ and R¹⁵ may be bonded to form a cyclic structure.

Regarding the phosphine compound that is used for the adduct of a phosphine compound and a quinone compound, for example, a compound in which the aromatic ring is unsubstituted or a substituent such as an alkyl group or an alkoxyl group is present in the aromatic ring, such as triphenylphosphine, a tris(alkylphenyl)phosphine, a tris(alkoxyphenyl)phosphine, trinaphthylphosphine, or tris(benzyl)phosphine, is preferred, and examples of the substituent such as an alkyl group or an alkoxyl group include those having 1 to 6 carbon atoms. Triphenylphosphine is preferred from the viewpoint of easy availability.

Furthermore, examples of the quinone compound that is used for the adduct of a phosphine compound and a quinone compound include benzoquinone and anthraquinones, and above all, p-benzoquinone is preferred from the viewpoint of storage stability.

Regarding a method for producing an adduct of a phosphine compound and a quinone compound, the adduct can be obtained by bringing an organic tertiary phosphine and a benzoquinone into contact with each other in a solvent in which both the compounds can be dissolved, and mixing the compounds. The solvent may be a solvent having low dissolvability for the adduct, among ketones such as acetone and methyl ethyl ketone. However, the compound is not limited to this.

The compound represented by General Formula (6), in which R¹⁰, R¹¹, and R¹² bonded to a phosphorus atom are each preferably a phenyl group, and R¹³, R¹⁴, and R¹⁵ are each preferably a hydrogen atom, that is, a compound produced by adding 1,4-benzoquinone to triphenylphosphine is preferable from the viewpoint that the compound decreases the elastic modulus during heating of a cured product of the resin composition for encapsulation.

Examples of the adduct of a phosphonium compound and a silane compound, which is used as the curing accelerator, include a compound represented by the following General Formula (7) .

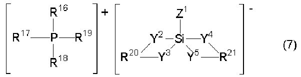

In the above-described General Formula (7), P represents a phosphorus atom, and Si represents a silicon atom. R¹⁶, R¹⁷, R¹⁸, and R¹⁹ each represent an organic group having an aromatic ring or a heterocyclic ring, or an aliphatic group, and may be the same as or different from each other. In Formula, R²⁰ is an organic group which is bonded to groups Y² and Y³. In Formula R²¹ is an organic group which is bonded to groups Y⁴ and Y⁵. Y² and Y³ each represent a group formed in a case where a proton-donating group releases a proton, in which the groups Y² and Y³ in the same molecule are bonded to a silicon atom to form a chelate structure. Y⁴ and Y⁵ each represent a group formed in a case where a proton-donating group releases a proton, in which the groups Y⁴ and Y⁵ in the same molecule are bonded to a silicon atom to form a chelate structure. R²⁰ and R²¹ may be the same as or different from each other, and the groups Y², Y³, Y⁴, and Y⁵ may be the same as or different from each other. Z¹ is an organic group having an aromatic ring or a heterocyclic ring, or an aliphatic group.

In General Formula (7), examples of R¹⁶, R¹⁷, R¹⁸, and R¹⁹ include a phenyl group, a methylphenyl group, a methoxyphenyl group, a hydroxyphenyl group, a naphthyl group, a hydroxynaphthyl group, a benzyl group, a methyl group, an ethyl group, an n-butyl group, an n-octyl group, and a cyclohexyl group, and among these, aromatic groups having a substituent such as an alkyl group, an alkoxy group, and a hydroxyl group, such as a phenyl group, a methylphenyl group, a methoxyphenyl group, a hydroxyphenyl group, and a hydroxynaphthyl group, or unsubstituted aromatic groups are more preferable.

Furthermore, in General Formula (7), R²⁰ is an organic group that is bonded to groups Y² and Y³. Similarly, R²¹ is an organic group which is bonded to groups Y⁴ and Y⁵. Y² and Y³ are each a group formed in a case where a proton-donating group releases a proton, in which the groups Y² and Y³ in the same molecule are bonded to a silicon atom to form a chelate structure.
Similarly, Y⁴ and Y⁵ are each a group formed in a case where a proton-donating group releases a proton, in which the groups Y⁴ and Y⁵ in the same molecule are bonded to a silicon atom to form a chelate structure. The groups R²⁰ and R²¹ may be the same as or different from each other, and the groups Y², Y³, Y⁴, and Y⁵ may be the same as or different from each other. Such groups represented by -Y²-R²⁰-Y³- and -Y⁴-R²¹-Y⁵- in General Formula (7) are each a group formed in a case where a proton donor releases two protons. As the proton donor, an organic acid having at least two carboxyl groups or hydroxyl groups in the molecule is preferable, an aromatic compound having at least two carboxyl groups or hydroxyl groups in the adjacent carbons constituting the aromatic ring is even more preferable, and an aromatic compound having at least two hydroxyl groups in the adjacent carbons constituting the aromatic ring is more preferable. Examples thereof include catechol, pyrogallol, 1,2-dihydroxynaphthalene, 2,3-dihydroxynaphthalene, 2,2'-biphenol, 1,1'-bi-2-naphthol, salicylic acid, 1-hydroxy-2-naphthoic acid, 3-hydroxy-2-naphthoic acid, chloranilic acid, tannic acid, 2-hydroxybenzyl alcohol, 1,2-cyclohexanediol, 1,2-propanediol, and glycerin, but among these, catechol, 1,2-dihydroxynaphthalene, and 2,3-dihydroxynaphthalene are more preferable.

Furthermore, Z¹ in General Formula (7) represents an organic group having an aromatic ring or a heterocyclic ring, or an aliphatic group, and specific examples thereof include aliphatic hydrocarbon groups such as a methyl group, an ethyl group, a propyl group, a butyl group, a hexyl group, and an octyl group; aromatic hydrocarbon groups such as a phenyl group, a benzyl group, a naphthyl group, and a biphenyl group; glycidyloxy groups such as a glycidyloxypropyl group, a mercaptopropyl group, and an aminopropyl group; and reactive substituents such as a mercapto group, an alkyl group having an amino group, and a vinyl group, while among these, a methyl group, an ethyl group, a phenyl group, a naphthyl group, and a biphenyl group are more preferred from the viewpoint of thermal stability.

Regarding a method for producing an adduct of a phosphonium compound and a silane compound, a silane compound such as phenyltrimethoxysilane and a proton donor such as 2,3-dihydroxynaphthalene are introduced into a flask containing methanol and dissolved, and then a sodium methoxide-methanol solution is added dropwise thereto while being stirred at room temperature. When a solution prepared in advance, in which a tetra-substituted phosphonium halide such as tetraphenylphosphonium bromide is dissolved in methanol, is further added dropwise while being stirred at room temperature, crystals are precipitated. When the precipitated crystals are filtered, washed with water, and vacuum-dried, an adduct of a phosphonium compound and a silane compound is obtained. However, the method is not limited to this.

The content of the curing accelerator is preferably equal to or more than 0.05% by mass, more preferably equal to or more than 0.08% by mass, and particularly preferably equal to or more than 0.10% by mass, with respect to the entire resin composition for encapsulation. By setting the content of the curing accelerator to be equal to or more than the above-described lower limit value, the curability of the resin composition for encapsulation at the time of transfer molding can be effectively enhanced. On the other hand, the content of the curing accelerator is preferably equal to or less than 2.0% by mass, more preferably equal to or less than 1.0% by mass, and particularly preferably equal to or less than 0.5% by mass, with respect to the entire resin composition for encapsulation. By setting the content of the curing accelerator to be equal to or less than the above-described upper limit value, the fluidity at the time of encapsulation can be enhanced, which can contribute to an enhancement of the filling property.

### (Inorganic filler)

Examples of the inorganic filler that is used for the resin composition for encapsulation of the present embodiment include fused silica such as fused crushed silica and fused spherical silica, crystalline silica, alumina, kaolin, talc, clay, mica, rock wool, wollastonite, glass powder, glass flakes, glass beads, glass fiber, silicon carbide, silicon nitride, aluminum nitride, carbon black, graphite, titanium dioxide, calcium carbonate, calcium sulfate, barium carbonate, magnesium carbonate, magnesium sulfate, barium sulfate, cellulose, aramid, wood, and pulverized powders obtained by pulverizing cured products of a phenol resin molding material and an epoxy resin molding material. Among these, silicas such as fused crushed silica, fused spherical silica, and crystalline silica are preferred, and fused spherical silica is more preferred. In addition, among these, calcium carbonate is preferable from a viewpoint of cost. Regarding the inorganic filler, one kind thereof may be used alone, or two or more kinds thereof may be used in combination.

The average particle size D₅₀ of the inorganic filler is preferably equal to or more than 0.01 um and equal to or less than 75 um, and more preferably equal to or more than 0.05 um and equal to or less than 50 um. By setting the average particle size of the inorganic filler to be within the above-described range, the filling property in the mold is improved. Furthermore, by setting the upper limit value of the average particle size of the inorganic filler to be equal to or less than 75 um, the filling property is further improved. The average particle size D₅₀ was defined as the volume-equivalent average particle size given by a laser diffraction type measuring apparatus, RODOS SR type (SYMPATEC HEROS & RODOS).

Furthermore, in the resin composition for encapsulation according to the present invention, the inorganic filler can include spherical silica having equal to or more than two kinds of different average particle sizes D₅₀. As a result, the fluidity and filling property at the time of transfer molding may be enhanced.

The content of the inorganic filler is preferably equal to or more than 50% by mass, more preferably equal to or more than 60% by mass, even more preferably equal to or more than 65% by mass, and particularly preferably equal to or more than 75% by mass, with respect to the entire resin composition for encapsulation. When the lower limit value is within the above-described range, an increase in the amount of moisture absorption and a decrease in strength concomitant with curing of the obtained resin composition for encapsulation can be reduced. Furthermore, the amount of the inorganic filler is preferably equal to or less than 93% by mass, more preferably equal to or less than 91% by mass, and even more preferably equal to or less than 90% by mass, with respect to the entire resin composition for encapsulation. When the upper limit value is within the above-described range, the obtained resin composition for encapsulation has satisfactory fluidity and also has satisfactory moldability. Therefore, the production stability of a single-sided encapsulation type structure is increased, and a structure having an excellent balance between product yield and durability is obtained.

In a case where silica such as fused crushed silica, fused spherical silica, or crystalline silica is used as the inorganic filler, the content of silica is preferably equal to or more than 40% by mass, and more preferably equal to or more than 60% by mass, with respect to the entire resin composition for encapsulation. When the lower limit value is within the above-described range, the balance between the fluidity and the coefficient of thermal expansion of the resin composition for encapsulation at the time of transfer molding is improved.

In a case where the inorganic filler is used in combination with an inorganic flame retardant, such as a metal hydroxide such as aluminum hydroxide or magnesium hydroxide, zinc borate, zinc molybdate, or antimony trioxide, it is desirable that the total amount of these inorganic flame retardants and the above-described inorganic filler is set to be within the range of the content of the above-described inorganic filler.

### (Wax)

The resin composition for encapsulation according to the present embodiment contains a wax. In the resin composition for encapsulation according to the present embodiment, a wax is contained, so that the molding shrinkage rate is reduced to about equal to or less than 0.1%. As the wax used in the resin composition for encapsulation according to the present embodiment, a wax having a melting point of 30°C to 90°C is preferably used. By including such a wax, the resin composition for encapsulation has satisfactory meltability at the temperature applied in transfer molding, thereby the fluidity at the time of encapsulation is enhanced, and the filling property may be enhanced. Examples of such a wax include natural waxes such as carnauba wax; synthetic waxes such as montanic acid ester wax and polyethylene oxide wax; and higher fatty acids such as zinc stearate, and metal salts thereof.

The blending amount of the wax is, for example, equal to or more than 0.05% by mass and equal to or less than 5.0% by mass with respect to the entire resin composition for encapsulation. The lower limit value of the blending amount of the wax is preferably equal to or more than 0.5% by mass, and more preferably equal to or more than 1.0% by mass, with respect to the entire resin composition for encapsulation. The upper limit value of the blending amount of the wax is preferably equal to or less than 4.5% by mass, and more preferably equal to or less than 4.0% by mass, with respect to the entire resin composition for encapsulation. The resin composition for encapsulation obtainable by blending the wax in the above-described range has excellent fluidity and filling property at the time of transfer molding.

### (Other additives)

The resin composition for encapsulation according to the present embodiment may further contain other additives such as coupling agents, adhesion aids, colorants, ion scavengers, flame retardants, and antioxidants, in addition to the above-described components, as necessary.

### (Coupling agent)

The resin composition for encapsulation according to the present invention may include a coupling agent such as a silane coupling agent in order to enhance the adhesiveness between the epoxy resin and the inorganic filler. Examples of the coupling agent include an epoxysilane, an aminosilane, an ureidosilane, and a mercaptosilane.

Examples of the epoxysilane include γ-glycidoxypropyltriethoxysilane, γ-glycidoxypropyltrimethoxysilane, γ-glycidoxypropylmethyldimethoxysilane, and β-(3,4-epoxycyclohexyl)ethyltrimethoxysilane. Examples of the aminosilane include γ-aminopropyltriethoxysilane, γ-aminopropyltrimethoxysilane, N-β-(aminoethyl)-γ-aminopropyltrimethoxysilane, N-β-(aminoethyl)-γ-aminopropylmethyldimethoxysilane, N-phenyl-γ-aminopropyltriethoxysilane, N-phenyl-γ-aminopropyltrimethoxysilane, N-β-(aminoethyl)-γ-aminopropyltriethoxysilane, N-6-(aminohexyl)-3-aminopropyltrimethoxysilane, and N-(3-(trimethoxysilylpropyl)-1,3-benzenedimethanane. Examples of the ureidosilane include γ-ureidopropyltriethoxysilane and hexamethyldisilazane. A latent aminosilane coupling agent having the primary amino moiety of aminosilane protected by reacting the primary amino moiety with a ketone or an aldehyde may also be used. Furthermore, the aminosilane may have a secondary amino group. Examples of the mercaptosilane include γ-mercaptopropyltrimethoxysilane and 3-mercaptopropylmethyldimethoxysilane, as well as a silane coupling agent that exhibits a function similar to that of a mercaptosilane coupling agent by thermal decomposition, such as bis(3-triethoxysilylpropyl) tetrasulfide or bis(3-triethoxysilylpropyl) disulfide. Furthermore, regarding these silane coupling agents, products that have been subjected to a hydrolysis reaction in advance may be blended. Regarding these silane coupling agents, one kind thereof may be used alone, or two or more kinds thereof may be used in combination.

From the viewpoint of continuous moldability, a mercaptosilane is preferred; from the viewpoint of fluidity, an aminosilane is preferred; and from the viewpoint of adhesion, an epoxysilane is preferred.

The lower limit value of the content of the coupling agent such as the silane coupling agent that can be used for the resin composition for encapsulation according to the present invention is preferably equal to or more than 0.01% by mass, more preferably equal to or more than 0.05% by mass, and particularly preferably equal to or more than 0.1% by mass, with respect to the entire resin composition for encapsulation. When the lower limit value of the content of the coupling agent such as a silane coupling agent is within the above-described range, the interface strength between the epoxy resin and the inorganic filler is not decreased, and satisfactory vibration resistance can be obtained. The upper limit value of the content of the coupling agent such as a silane coupling agent is preferably equal to or less than 1% by mass, more preferably equal to or less than 0.8% by mass, and particularly preferably equal to or less than 0.6% by mass, with respect to the entire resin composition for encapsulation. When the upper limit value of the content of the coupling agent such as a silane coupling agent is within the above-described range, the interface strength between the epoxy resin and the inorganic filler is not decreased, and satisfactory vibration resistance can be obtained. Furthermore, when the content of the coupling agent such as the silane coupling agent is within the above-described range, the water absorbability of a cured product of the resin composition for encapsulation is prevented from increasing.

### (Adhesion aid)

The resin composition for encapsulation according to the present invention may contain an adhesion aid in order to improve adhesiveness between the encapsulation portion obtained by curing the resin composition for encapsulation and a substrate. Examples of the adhesion aid include triazole compounds, and examples of the triazole compounds include compounds having a 1,2,4-triazole ring and compounds having a 1,2,3-triazole ring. Specific examples of the compound include 3-amino-1,2,4-triazole, 4-amino-1,2,3-triazole, 3-amino-1,2,4-triazole-5-carboxylic acid, 3-mercapto-1,2,4-triazole, 4-mercapto-1,2,3-triazole, 3,5-diamino-1,2,4-triazole, 3,5-dimercapto-1,2,4-triazole, 4,5-dimercapto-1,2,3-triazole, 3-amino-5-mercapto-1,2,4-triazole, 4-amino-5-mercapto-1,2,3-triazole, 3-hydrazino-4-amino-5-mercapto-1,2,4-triazole, and 5-mercapto-1,2,4-triazole-3-methanol. Among these, one or more kinds thereof can be used in combination. Among these, a compound having at least one mercapto group is preferable.

A content of the adhesion aid in the resin composition for encapsulation is preferably 0.01% to 2% by mass and more preferably 0.03% to 1% by mass with respect to the entire mass of the resin composition for encapsulation. By setting the content of the adhesion aid within such a range, the above-described effect can be more remarkably exhibited.

### (Colorant)

Examples of the colorant used in the resin composition for encapsulation according to the present embodiment include carbon black, iron oxide red, titanium oxide, phthalocyanine, and perylene black.

### (Ion scavenger)

Examples of the ion scavenger used in the resin composition for encapsulation according to the present embodiment include hydrotalcite; hydroxides of elements selected from magnesium, aluminum, bismuth, titanium, and zirconium.

From the viewpoint of improving reliability of a semiconductor device, the content of the ion scavenger in the resin composition for encapsulation is preferably equal to or more than 0.03% by mass and more preferably equal to or more than 0.05% by mass with respect to the entire resin composition for encapsulation, and is preferably equal to or less than 2.0% by mass and more preferably equal to or less than 1.0% by mass.

### (Flame retardant)

Examples of the flame retardant used in the resin composition for encapsulation according to the present embodiment include a brominated epoxy resin, antimony trioxide, aluminum hydroxide, magnesium hydroxide, zinc borate, zinc molybdate, and a phosphazene.

### (Antioxidant)

Examples of the antioxidants used in the resin composition for encapsulation according to the present embodiment include hindered phenol-based compounds, hindered amine-based compounds, and thioether-based compounds.

### [Method for producing resin composition for encapsulation]

The resin composition for encapsulation of the present embodiment can be produced by uniformly mixing the above-described components and additives that are used as necessary, to obtain predetermined contents, by using a mixer such as a tumbler mixer or a Henschel mixer, a blender, or the like, and then kneading the mixture while heating with a kneader, a roll, a Disper, an Agi Homo Mixer, a planetary mixer, and the like. The temperature during kneading needs to be in a temperature range in which no curing reaction occurs, and although the temperature may vary depending on the composition of the epoxy resin and the curing agent, it is preferable to perform melt-kneading at about 70°C to 150°C. After kneading, the mixture may be cooled and solidified, and the kneaded product may be processed into a powdered form, a granular form, a tablet form, or a sheet form.

Regarding a method of obtaining a powdered resin composition, for example, a method of pulverizing the kneaded product by using a pulverizing apparatus may be mentioned. The kneaded product that has been molded into a sheet may be pulverized. As the pulverizing apparatus, for example, a hammer mill, a stone mill-type grinding mill, or a roll crusher can be used.

As a method of obtaining a granular resin composition, for example, a granulation method represented by a hot cut method of installing a die having a small diameter at an output of a kneading device and cutting a kneaded product in a molten state that is discharged through the die into a predetermined length with a cutter or the like, may be used. In this case, after obtaining a granular or powdered resin composition by a granulation method such as the hot-cut method, it is preferable to perform degassing before the temperature of the resin composition does not decrease excessively.

As a method for obtaining a tablet-like resin composition, for example, a method of supplying the above-described powdered resin composition to an extruder including a screw and a die provided at a distal end of the screw, heating and melting the resin composition, then extruding the molten resin composition from the die by rotation of the screw, and cutting the extruded resin composition to a predetermined length to obtain the tablet-like resin composition can be used.

In the resin composition for encapsulation according to the present embodiment, which contains the above-described components in a predetermined amount, the molding shrinkage rate is equal to or less than 0.1%. Here, the molding shrinkage rate is measured by a method conforming to JIS K6911 of the cured product of the resin composition for encapsulation. The molding shrinkage rate of the resin composition for encapsulation is preferably equal to or less than 0.09%, and more preferably equal to or less than 0.08%. Since the molding shrinkage rate is equal to or less than the above-described value, warping of the obtained single-sided encapsulation type structure on an encapsulation resin side is reduced, and thus a single-sided encapsulation type structure having excellent reliability is obtained.

In the resin composition for encapsulation according to the present embodiment, which contains the above-described components in a predetermined amount, a glass transition temperature of the cured product is, for example, 150°C to 250°C, and preferably 180°C to 220°C.

In the resin composition for encapsulation according to the present embodiment, which contains the above-described components in a predetermined amount, a linear expansion coefficient of the cured product of 40°C to 80°C, for example, equal to or more than 9 ppm/K and equal to or less than 13 ppm/K, and preferably equal to or more than 9 ppm/K and equal to or less than 12 ppm/K. In the resin composition for encapsulation according to the present embodiment, since a thermal expansion coefficient during heating is suppressed, deformation (thermal expansion and thermal shrinkage) generated during heating or cooling in a curing process of the resin can be suppressed, and as a result, warping of the obtained single-sided encapsulation structure on the encapsulation resin side is reduced, thus a single-sided encapsulation type structure having excellent reliability is obtained.

### [Use of resin composition for encapsulation]

The resin composition for encapsulation according to the present embodiment is used for producing a single-sided encapsulation type structure. More specifically, the single-sided encapsulation type structure according to the present embodiment is produced by mounting an electronic device on one surface of a motherboard and encapsulating the surface of the motherboard on which the electronic device is mounted with the resin composition according to the present embodiment.

The method for producing a single-sided encapsulation type structure according to the present embodiment includes a step of collectively encapsulating a relatively large-area motherboard on which an electronic device is mounted, using the resin composition for encapsulation according to the present embodiment. More specifically, first, a motherboard on which the electronic device is mounted is disposed in a mold at a predetermined temperature (for example, 150°C to 190°C). Next, the resin composition for encapsulation of the present embodiment is injected and filled into the mold (filling space) with a predetermined molding pressure (for example, 3 to 10 MPa) by using a plunger, and the resin encapsulation molding is performed, for example, for 90 to 180 seconds. Thereafter, post-curing is optionally performed at a predetermined curing temperature and curing time (for example, 150°C to 190°C, 2 to 6 hours) as necessary. As a result, a single-sided encapsulation structure is obtained.

The large-area motherboard used in the method for producing a single-sided encapsulation structure according to the present embodiment refers to a substrate having a diameter equal to or more than 150 mm, or a quadrangular dimension in which a vertical length is equal to or more than 150 mm and a horizontal length is equal to or more than 150 mm in the present invention. In a specific embodiment, a substrate in which a vertical length is 150 mm to 400 mm and a horizontal length is 150 mm to 400 mm is used. A thickness of the substrate need only be such that the substrate has a support function during molding, and is preferably 30 um to 5,000 um, and more preferably 50 um to 3,000 um. Examples of materials for the motherboard include a copper or aluminum substrate having a surface subjected to an insulating treatment, a glass epoxy substrate, a bismaleimide triazine (BT) resin substrate, and a fiber-reinforced plastic (FRP) substrate, particularly, a glass epoxy substrate, a BT resin substrate, or a ceramic substrate is preferably used.

In the single-sided encapsulation structure obtained by the method according to the present embodiment, a thickness of the encapsulation resin can be appropriately adjusted according to dimensions of the electronic device mounted on the motherboard, and can be set to, for example, 0.1 to 10 mm, is preferably 0.2 to 8 mm.

The single-sided encapsulation type structure obtained by the method according to the present embodiment can be mounted on, for example, a vehicle such as a hybrid vehicle, a fuel cell vehicle, or an electric vehicle.

Thus, the embodiments of the present invention have been described above; however, these are only examples of the present invention, and various configurations other than the above-described ones can be employed.

### Examples

Hereinafter, the present invention will be described with reference to Examples and Comparative Examples; however, the present invention is not intended to be limited thereto.

The components used in Examples are shown below.

### (Epoxy resin)

- Epoxy resin 1: Triphenylmethane-type epoxy resin (manufactured by Mitsubishi Chemical Corporation, E-1032H60)
- Epoxy resin 2: Biphenyl-type epoxy resin (manufactured by Mitsubishi Chemical Corporation, YX4000K)
- Epoxy resin 3: Biphenyl aralkyl-type epoxy resin (manufactured by Nippon Kayaku Co., Ltd., NC-3000)
- Epoxy resin 4: Bisphenol A-type epoxy resin (manufactured by Mitsubishi Chemical Corporation, YL6810)

### (Curing agent)

- Curing agent 1: Trisphenylmethane-type phenol novolac resin (manufactured by Meiwa Chemical Co., Ltd., MEH-7500)
- Curing agent 2: Biphenyl aralkyl-type phenol resin (manufactured by Meiwa Chemical Co., Ltd., MEH-7851SS)
- Curing agent 3: Novolac-type phenol resin (manufactured by Sumitomo Bakelite Co., Ltd., PR-HF-3)

### (Curing accelerator)

- Curing accelerator 1: Tetraphenylphosphonium 4,4-sulfonyldiphenolate
- Curing accelerator 2: Triphenylphosphine (manufactured by K.I Chemical Industry Co., Ltd., PP-360)
- Curing accelerator 3: Tetraphenylphosphonium 2,3-dihydroxynaphthalate

### (Inorganic filler)

- Inorganic filler 1: Silica filler (manufactured by Admatechs Co., Ltd., SO-25R, average diameter: 0.5 um)
- Inorganic filler 2: Silica filler (manufactured by Denka Company Limited, FB-105, average diameter: 11 um)
- Inorganic filler 3: Silica filler (manufactured by Denka Company Limited, FB-950, average diameter: 23 um)

### (Wax)

- Wax 1: Carnauba wax (manufactured by Toagosei Co., Ltd., TOWAX-132)
- Wax 2: Diethanolamine dimontanate ester (manufactured by Itoh Oil Chemical Co., Ltd., ITOHWAX TP NC-133)
- Wax 3: Stearic acid (manufactured by NOF Corporation, SR-SAKURA)

### (Coupling agent)

- Coupling agent 1: N-phenyl-3-aminopropyltrimethoxysilane (Dow Corning Toray Co., Ltd., CF-4083)
- Coupling agent 2: 3-glycidoxypropyltrimethoxysilane (manufactured by JNC Corporation, GPS-M)
- Coupling agent 3: γ-mercaptopropyltrimethoxysilane (manufactured by Shin-Etsu Chemical Co., Ltd., KBM803P)

### (Adhesion aid)

- Adhesion aid 1: 3-amino-5-mercapto-1,2,4-triazole

### (Colorant)

- Colorant 1: Carbon black (Mitsubishi Chemical Corporation, CARBON #5)

### (Curing inhibitor)

- Curing inhibitor 1: 2,3-dihydroxynaphthalene

### (Ion scavenger)

- Ion scavenger 1: Hydrotalcite (DHT-4H manufactured by Kyowa Chemical Industry Co., LTD)

### (Low stress agent)

- Low stress agent 1: silicone rubber (manufactured by Dow Corning Toray Co., Ltd., CF-2152)
- Low stress agent 2: Mixture of butadiene-acrylonitrile-2,3-epoxypropyl=methacrylate-divinylbenzene copolymer and talc

### (manufactured by JSR Corporation)

- Low stress agent 3: Epoxy polyether-modified silicone oil (FZ-3730 manufactured by Dow Corning Toray Co., Ltd.)

### (Examples 1 to 3 and Comparative Examples 1 to 3)

Using the above-described raw materials, each component was mixed at 15°C to 28°C using a mixer to have Composition (parts by mass) shown in Table 1. Next, the obtained mixture was roll-kneaded at 70°C to 100°C, and then was cooled and pulverized to obtain each resin composition for encapsulation.

### <Measurement and evaluation of physical properties>

Measurement of the following physical properties and evaluation and measurement of the following items were performed for each obtained resin composition for encapsulation. The results are shown in Table 1.

### (Molding shrinkage rate)

A molding shrinkage rate of the cured product of the resin composition for encapsulation obtained in each example was measured as follows.

Using a low-pressure transfer molding machine (manufactured by Kotaki Seiki Co., Ltd., KTS-30), each resin composition was injection-molded under conditions of a mold temperature of 175°C, an injection pressure of 6.9 MPa, and a curing time of 120 seconds to obtain a molded product of a diameter of 90 mm × a thickness of 5 mm. Next, the obtained molded product was post-cured under conditions of 175°C for 4 hours to obtain a specimen consisting of a cured product of each resin composition. Next, the molding shrinkage rate of the specimen obtained by the method conforming to JIS K6911 was measured. A unit of the molding shrinkage rate is %.

### (Glass transition temperature)

The glass transition temperature of the cured product of the resin composition for encapsulation obtained in each example was measured as follows.

First, a resin composition was injection-molded using a low-pressure transfer molding machine ("KTS-15" manufactured by Kohtaki Corporation) at a mold temperature of 175°C, an injection pressure of 6.9 MPa, and a curing time of 120 seconds, and a specimen having a size of 10 mm × 4 mm × 4 mm was obtained. Next, the obtained test piece was post-cured at 175°C for 4 hours, and then measurement was performed using a thermomechanical analyzer (manufactured by Seiko Instruments, Inc., TMA100) under the conditions of a measurement temperature range of 0°C to 320°C and a rate of temperature increase of 5°C/min. Then, the glass transition temperature (°C) was calculated from the measurement results.

### (Linear expansion coefficient)

The cured product of the resin composition obtained in each example was set in a thermomechanical analyzer (manufactured by Seiko Instruments Inc., TMA100), and measured under conditions of a temperature range of 0°C to 320°C and a temperature rising rate of 5°C/min. Measurement data was analyzed to obtain an average linear expansion coefficient in a temperature range of 40°C to 80°C. A unit of the average linear expansion coefficient is [ppm/K].

### (Fluidity (spiral flow))

A spiral flow measurement was performed with respect to the resin composition obtained in each example. The spiral flow measurement was performed by injecting the resin composition for encapsulation into a mold for spiral flow measurement according to EMMI-1-66 by using a low-pressure transfer molding machine (manufactured by Kohtaki Corporation, "KTS-15") under the conditions of a mold temperature of 175°C, an injection pressure of 6.9 MPa, and a curing time of 120 seconds, and measuring the flow length (cm).

### (Warping amount)

For Examples and Comparative Examples, a substrate encapsulated by using a resin composition for encapsulation as described below was prepared, and warping of the encapsulated substrate was evaluated.

A resin composition for encapsulation was transfer-molded onto only a circuit surface of a substrate (6 layers, 200 mm × 100 mm × 1.6 mm thickness, PCB substrate having a copper residual rate of 60% to 70%, connector mounted for external connection, Tg equal to or higher than 150°C, elastic modulus of 24.3 GPa, CTE of 14 ppm/K, and Poisson's ratio of 0.3) under conditions of a mold temperature of 175°C, a molding pressure of 6 MPa, and a curing time of 5 minutes, such that a molded resin thickness of 4 mm was obtained, thereby obtaining a encapsulated substrate. Next, the obtained encapsulated substrate was post-cured at 175°C for 4 hours, then the encapsulated substrate was placed to have a convex on an upper side, so that a difference in height between highest and lowest positions was measured. This difference was defined as the warping amount of the encapsulated substrate.

**Table 1**

| <Composition of resin composition> | | Unit | Example 1 | Example 2 | Example 3 | Comparative Example 1 | Comparative Example 2 | Comparative Example 3 |
|---|---|---|---|---|---|---|---|---|
| Adhesion aid | Adhesion aid 1 | % by mass | 0.10 | - | - | 0.10 | - | - |
| Colorant | Colorant 1 | % by mass | 0.30 | 0.30 | 0.30 | 0.30 | 0.30 | 0.30 |
| Curing inhibitor | Curing inhibitor 1 | % by mass | - | 0.10 | - | 0.15 | - | - |
| Curing accelerator | Curing accelerator 1 | % by mass | 0.15 | - | - | 0.25 | - | - |
| | Curing accelerator 2 | % by mass | - | 0.10 | - | - | - | - |
| | Curing accelerator 3 | % by mass | - | - | 0.15 | - | 0.40 | 0.30 |
| Coupling agent | Coupling agent 1 | % by mass | 0.15 | 0.20 | 0.10 | 0.15 | 0.10 | 0.10 |
| | Coupling agent 2 | % by mass | 0.05 | | 0.05 | 0.05 | - | 0.10 |
| | Coupling agent 3 | % by mass | 0.05 | | 0.05 | 0.05 | 0.10 | 0.10 |
| Epoxy resin | Epoxy resin 1 | % by mass | 8.80 | 4.25 | 9.25 | 5.10 | - | - |
| | Epoxy resin 2 | % by mass | - | 1.40 | - | - | 6.75 | - |
| | Epoxy resin 3 | % by mass | - | - | - | 3.35 | - | 0.85 |
| | Epoxy resin 4 | % by mass | - | - | - | - | - | 3.40 |
| Inorganic filler | Inorganic filler 1 | % by mass | 10.00 | 15.00 | 10.00 | 10.00 | 15.00 | 15.00 |
| | Inorganic filler 2 | % by mass | 20.00 | 75.00 | - | 20.00 | 30.00 | 25.50 |
| | Inorganic filler 3 | % by mass | 51.50 | - | 74.50 | 51.50 | 42.50 | 50.00 |
| Curing agent | Curing agent 1 | % by mass | 4.65 | 3.35 | 5.10 | 2.20 | - | - |
| | Curing agent 2 | % by mass | - | - | - | 1.50 | 2.10 | 3.70 |
| | Curing agent 3 | % by mass | - | - | - | - | 2.10 | - |
| Ion scavenger | Ion scavenger 1 | % by mass | 0.10 | - | - | 0.10 | 0.10 | - |
| Wax | Wax 1 | % by mass | 0.20 | 0.15 | 0.20 | 0.20 | 0.05 | 0.20 |
| | Wax 2 | % by mass | 0.15 | - | - | - | 0.20 | 0.15 |
| | Wax 3 | % by mass | - | - | - | - | 0.05 | 0.05 |
| Low stress agent | Low stress agent 1 | % by mass | 3.00 | - | - | 3.00 | - | - |
| | Low stress agent 2 | % by mass | 0.50 | - | - | 1.00 | - | - |
| | Low stress agent 3 | % by mass | 0.30 | 0.15 | 0.30 | 1.00 | 0.25 | 0.25 |
| Total | | % by mass | 100.00 | 100.00 | 100.00 | 100.00 | 100.00 | 100.00 |

| <Physical properties of resin composition> | | | | | | | | |
|---|---|---|---|---|---|---|---|---|
| Molding shrinkage rate | | % | 0.08 | 0.06 | 0.09 | 0.11 | 0.16 | 0.12 |
| Glass transition temperature | | °C | 200 | 180 | 200 | 175 | 150 | 130 |
| Linear expansion coefficient | | ppm/K | 11 | 7 | 13 | 11 | 9 | 7 |
| Spiral flow | | cm | 115 | 125 | 100 | 80 | 210 | 120 |

| <Evaluation> | | | | | | | | |
|---|---|---|---|---|---|---|---|---|
| Warping amount | | µm | -200 | -200 | -200 | 790 | 1600 | 800 |

In the substrate produced by using the resin composition of Examples as an encapsulant, the warping amount was reduced. Therefore, the substrate can be suitably used for producing a single-sided encapsulation type structure having excellent reliability.

This application claims priority on the basis of Japanese Patent Application No. 2022-050381, filed March 25, 2022, the disclosure of which is incorporated herein in its entirety by reference.

## Claims

1. A resin composition for encapsulation used for producing a single-sided encapsulation type structure by performing single-sided encapsulation on a motherboard on which at least one electronic device is mounted, the resin composition for encapsulation comprising:
a trifunctional or higher epoxy resin;
a curing agent;
a curing accelerator;
an inorganic filler; and
a wax,
wherein a molding shrinkage rate of the resin composition for encapsulation is equal to or less than 0.1%.

2. The resin composition for encapsulation according to Claim 1,
wherein a glass transition temperature Tg is equal to or higher than 150°C and equal to or lower than 250°C.

3. The resin composition for encapsulation according to Claim 1 or 2,
wherein an average linear expansion coefficient at 40°C to 80°C is 9 to 13 ppm/K.

4. The resin composition for encapsulation according to any one of Claims 1 to 3,
wherein an amount of the wax is equal to or more than 0.05% by mass and equal to or less than 5% by mass with respect to an entire resin composition for encapsulation.

5. The resin composition for encapsulation according to any one of Claims 1 to 4,
wherein an amount of the inorganic filler is equal to or more than 80% by mass and equal to or less than 90% by mass with respect to an entire resin composition for encapsulation.

6. The resin composition for encapsulation according to any one of Claims 1 to 5, further comprising:
a triazole.

7. The resin composition for encapsulation according to any one of Claims 1 to 6,
wherein the resin composition for encapsulation has a tablet shape.

8. A method for producing a single-sided encapsulation structure, the method comprising:
a step of preparing a structure including a motherboard and an electronic device mounted on one surface of the motherboard; and
a step of obtaining a single-sided encapsulation structure by encapsulating the surface of the structure, on which the electronic device is mounted, with a resin composition for encapsulation,
wherein the resin composition for encapsulation contains a trifunctional or higher epoxy resin, a curing agent, a curing accelerator, an inorganic filler, and a wax, and
a molding shrinkage rate of the resin composition for encapsulation is equal to or less than 0.1%.

9. The method for producing a single-sided encapsulation structure according to Claim 8,
wherein the step of preparing the structure including the motherboard and the electronic device mounted on the one surface of the motherboard includes a step of performing a surface treatment on the motherboard.

10. The method for producing a single-sided encapsulation structure according to Claim 8 or 9,
wherein a glass transition temperature Tg of the resin composition for encapsulation is equal to or higher than 150°C and equal to or lower than 250°C.

11. The method for producing a single-sided encapsulation structure according to any one of Claims 8 to 10,
wherein an average linear expansion coefficient of the resin composition for encapsulation at 40°C to 80°C is 9 to 13 ppm/K.

12. The method for producing a single-sided encapsulation structure according to any one of Claims 8 to 11,
wherein a content of the wax in the resin composition for encapsulation is equal to or more than 0.05% by mass and equal to or less than 5% by mass with respect to an entire resin composition for encapsulation.

13. The method for producing a single-sided encapsulation structure according to any one of Claims 8 to 12,
wherein a content of the inorganic filler in the resin composition for encapsulation is equal to or more than 80% by mass and equal to or less than 90% by mass with respect to an entire resin composition for encapsulation.

14. The method for producing a single-sided encapsulation structure according to any one of Claims 8 to 13,
wherein the resin composition for encapsulation further contains a triazole.

15. The method for producing a single-sided encapsulation structure according to any one of Claims 8 to 14,
wherein the resin composition for encapsulation has a tablet shape.
